# EUROPÄISCHE PATENTSCHRIFT

(11) **EP 1 385 266 B1**
(45) Veröffentlichungstag und Bekanntmachung des Hinweises auf die Patenterteilung: **14.07.2010**
(21) Anmeldenummer: 03016123.6
(22) Anmeldetag: 16.07.2003
(51) Int. Cl.: H03K 3/02, H03C 1/14

(54) **Mikrowellen-Pulsgenerator**
Microwave pulse generator
Générateur d'impulsions à micro-ondes

(30) Priorität: 24.07.2002 DE 10233569
(43) Veröffentlichungstag der Anmeldung: 28.01.2004
(73) Patentinhaber: VEGA Grieshaber KG, 77709 Wolfach (DE)
(72) Erfinder: Schultheiss, Daniel, 78132 Hornberg (DE); Rauer, Winfried, 77716 Fischerbach (DE)
(74) Vertreter: Göhring, Robert

(56) Entgegenhaltungen:
- RU-C- 2 013 000
- SU-A- 663 080
- US-A- 4 755 772
- US-B1- 6 252 470

## Beschreibung

Die Erfindung betrifft einen Mikrowellen-Pulsgenerator zur Erzeugung von Mikrowellen-Impulsen im Nanosekundenbereich gemäß den Merkmalen des Oberbegriffs des Anspruchs 1.

Derartige Mikrowollen-Pulsgeneratoren werden üblicherweise in Radarsystemen, insbesondere in Pulsradarsystemen, zur genauen Entfernungsmessung verwendet.

Beschrieben sind solche Mikrowellen-Pulsgeneratoren z. B. in DE 197 02 261 C2. Die dortigen Mikrowellen-Pulsgeneratoren haben den Vorteil, das durch die Erzeugung von Impulsen geeigneter Dauer, welche zur Spannungsversorgung eines Mikrowellenoszillators bereitgestellt werden, der Schaltungsaufwand erheblich im Vergleich zu anderen Mikrowellen-Pulsgeneratoren reduziert ist. Zudem benötigt die bekannte Anordnung keine teuren Ladungsspeicherdioden. Der Impuls im Nanosekundenbereich, welcher die Dauer des eigentlichen Mikrowellen-Pulses bestimmt, kann durch eine einfache Imputsverkürzungsstufe erzeugt werden.

In einer Weiterbildung kann die Ankopplung von Impulsverkürzungsstufe und Oszillator durch eine Treiberstufe und/oder eine Entkopplungsstufe verbessert werden. Sollte die Impulsverkürzungsstufe derart aufgebaut sein, dass sie ein invertiertes Ausgangssignal erzeugt, so kann dies durch eine invertierende Treiberstufe kompensiert werden. Die Entkopplungsstufe kann vorteilhafterweise durch einen circular stub erfolgen.

Als weiterer Stand der Technik werden die US 4,755,772 und die RU 2 103 000 C genannt.

Der Mikrowellen-Pulsgenerator aus DE 197 02 261 C2 wird nochmals anhand von drei Figuren näher erläutert. In Figur 1 ist mit 1 ein Impulsgenerator bezeichnet, dessen Ausgangssignal dem Eingang einer Impulsverkürzungsstufe 2 zugeführt wird. Die Impulsverkürzungsstufe 2 erzeugt Ausgangsimpulse im Nanosekundenbereich, die dem Eingang einer Treiberstufe 3 zugeführt werden. Das von der Treiberstufe 3 verstärkte Signal wird einem Entkopplungsnetzwerk 4 zugeführt, weiches ausgangsseitig mit dem Versorgungsspannungseingang eines Mikrowellenoszillators 5 verbunden ist. Das Ausgangsignal des Mikrowellenoszillators 5 ist an einer Ausgangsklemme 24 abgreifbar.

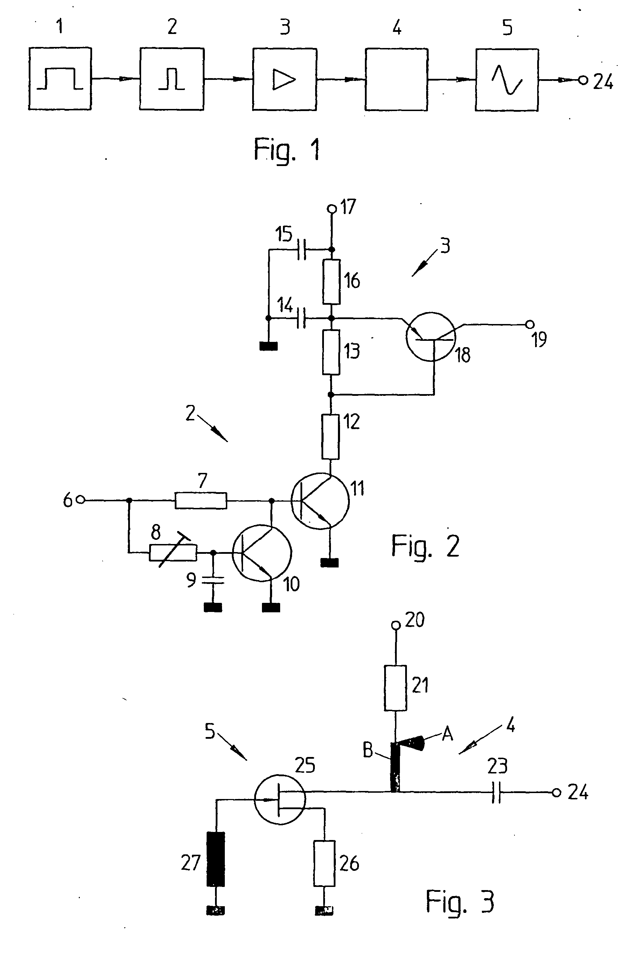

Der Impulsgenerator liefert eine Impulsfolge mit einer vorgegebenen Impulsperiode. Gemäß Figur 2 kann die nachgeschaltete Impulsverkürzungsstufe 2 eine Eingangsklemme 6 aufweisen, welche über einen Widerstand 7 mit der Basis eines npn-Transistors 11 und über einen Widerstand 8 mit der Basis einen npn-Transistors 10 verbunden ist. Zwischen Widerstand 8 und Basis des Transistors 10 ist eine Kapazität 9 gegen Masse geschaltet. Der Kollektor des Transistors 10 ist mit der Basis des Transistors 11 und der Emitter des Transistors 10 mit Masse verbunden. Ebenso ist der Emitter des Transistors 11 mit Masse verschaltet. Der Kollektor des Transistors 11 bildet den Ausgangskreis der Impulsverkürzungsstufe und ist mit dem Eingangskreis der nachgeschalteten Treiberstufe 3 gekoppelt. Hierzu ist der Kollektor über eine Reihenschaltung aus drei Widerständen 12, 13 und 16 mit einer Versorgungsspannungsklemme 17 verbunden. Der Mittelabgriff der Reihenschaltung des Widerstands 12 und 13 ist mit der Basis eines pnp-Transistors 18 verschaltet, der Mittelabgriff der Reihenschaltung aus Widerstand 13 und 16 mit dem Emitter des Transistors 18. Dessen Kollektor ist mit einer Ausgangsklemme 19 verbunden. Der Widerstand 16 ist beidseitig über Entkopplungskapazitäten 15 und 16 mit Masse verbunden.

Der Mikrowellenoszillator weist gemäß Figur 3 eine Versorgungsklemme 20 auf. Diese ist über einen Widerstand 21 mit einem circular stub A und einer λ/4-Leitung B verbunden. Ausgangsseitig ist die λ/4-Leitung B über eine Kapazität 23 mit der Ausgangsklemme 24 verschaltet und über die Lastrecke eines Feldeffekttransistors 25 und einen dazu in Reihe geschalteten Widerstand 26 mit Masse verbunden. Der Gateanschluß des Feldeffekttransistors 25 ist über eine Induktivität 27 mit Masse verbunden.

Ausgang 19 der Treiberstufe 3 wird mit der Versorgungsklemme 20 verbunden. Der Eingangsklemme 6 wird eine Impulsfolge mit vorgegebener Impulsperiode zugeführt. Der ankommende Impuls des Impulsgenerators 1 wird in der Impulsvcrkürzungsstufe 2 auf die Länge tₚ verkürzt. Dies geschieht im Ausführungsbeispiel gemäß Figur 2 dadurch, daß die positive Flanke des eingehenden Impulses bei Überschreiten der Basis-Emitter-Spannung des Transistor 11 diesen in den leitenden Zustand überführt. Dadurch wird der Spannungsteiler 12, 13, 16 bestromt und damit fällt am Widerstand 13 genug Spannung ab, um den Transistor 18 leitend zu schalten. Gleichzeitig wird die positive Flanke des eingehenden Impulses über das RC-Glied 8, 9 um die durch sie definierte Zeit verzögert. Diese Verzögerungszeit läßt sich durch Wahl von schnellen Transistoren von Bruchteilen einer Nanosekunde bis zur Länge des eingehenden Impulses einstellen. Nach Ablauf dieser Verzögerungszeit wird der Transistor 10 leitend geschaltet, so daß die Spannung an der Basis von Transistor 11 auf die Sättigungsspannung von Transistor 10 reduziert wird. Transistor 11 kehrt somit wieder in den hochohmigen Zustand zurück und sperrt dadurch auch Transistor 18. Am Ausgang 19 steht damit ein sehr kurzer Impuls der Länge tₚ zur Verfügung, welcher zudem niederohmig belastbar ist. Das Netzwerk 14, 15, 16 dient lediglich zur Abblockung der Betriebsspannung, die an der Klemme 17 angelegt ist. Impulsverkürzungsstufe 2 und Treiberstufe 3 ergänzen sich im vorliegenden Beispiel insofern, da beide Stufen das zu verarbeitende Signal invertieren, wodurch ein nicht invertiertes Signal am Ausgang 19 abgreifbar ist.

Das so gewonnene Signal mit einer Impulsdauer, die der Dauer des Mikrowellen-Pulses entspricht, wird dem Mikrowellenoszillator als Versorgungsspannung über die Klemmen 19 und 20 zur Verfügung gestellt. Der Mikrowellenoszillator besteht aus einem Transistor 25, der im vorliegenden Beispiel als Gallium-Arsenit-Feldeffekttransistor ausgeführt ist. Es könnte aber auch ein geeigneter bipolarer Transistor verwendet werden. Des weiteren ist z. B. die Induktivität als induktives TEM-Leitungsstück ausgeführt. Der Resonanzkreis des Oszillators 5 wird aus diesem Leitungsstück 27 und der internen Transitorkapazität zwischen Gate und Drain bei FET's, bzw. Basis und Kollektor bei einem Bipolartransistor, gebildet. Dabei bildet das Leitungsstück 27 zusammen mit der Transistorkapazität einen Serienresonanzkreis, der über die Länge der Leitung 27 abgestimmt werden kann. Des weiteren wird dadurch die Phasenbedingung für das Anschwingen erfüllt. Der Widerstand 26 wird zur Reduzierung der Resonanzkreisgüte benötigt, damit ein schnelles Anschwingen gewährleistet wird. Zur Begrenzung des Stroms durch den Transistor 2.5 ist in der Zuleitung zwischen Treiberstufe 3 und Entkopplungsnetzwerk 4 ein Widerstand 21 eingefügt. Der Kondensator 23 dient zur Abblockung der Versorgungsspannung und koppelt so das Ausgangsignal des Oszillators aus.

Der Mikrowellenoszillator 5 ist derart ausgestaltet, daß er bei Anlegen einer Versorgungsspannung an der Klemme 20 auf der Resonanzfrequenz des bestimmenden Resonanzkreises ein CW-Signal erzeugt. Bei der Anpassung der Leitungslänge des Leitungsstücks 27 ist zu beachten, daß der transformierte Anteil der Eigeninduktivität des Widerstandes 26 parallel zur Induktivität 27 berücksichtigt werden muß.

Wie bereits beschrieben erfolgt die Spannungsversorgung des Mikrowellenosziliators 5 durch einen Impuls der Länge tₚ. Dieser wird zur Entkopplung der Impulsverkürzungsstufe und der nachgeschalteten Treiberstufe 3 über das Entkopplungsnetzwerk bestehend aus einem circular stub A und einer λ/4-Leitung B dem Mikrowellenoszillator 5 zugeführt. Die Länge diese Impulses bestimmt damit die Länge des Mikrowellenpulses.

Um ein schnelles Ein- und Ausschwingverhalten zu erreichen, muß der Source-Anschluß über einen Widerstand 26 mit Masse verbunden sein. Dieser Widerstand 26 reduziert die Resonanzkreisgüte soweit, daß der Oszillator nach der halben Impulslänge, also im Maximum der Impulsamplitude, gerade seine maximale Amplitude erreicht hat. Von hier ab nimmt die Impulsamplitude und damit auch die Amplitude der Mikrowellenschwingung ab, bis die Impulsamplitude wieder bei Null angelangt ist.

Die Kohärenz der Mikrowellenschwingung wird dadurch erreicht, daß der etwa eine Nanosekunde lange Impuls zur Versorgung des Oszillators 5 eine kleine Anstiegzeit besitzt, die im Bereich von 250 ps liegt und damit bereits einen spektralen Energieanteil auf der Resonanzfrequenz in den Oszillator einkoppelt. Dadurch ist die Anfangsphase des Mikrowellensignals fest eingeprägt.

Am Ausgang 24 des Oszillators 5 wird der Mikrowellenpuls über die Kapazität 23 ausgekoppelt. Hier ist dem Mikrowellenpuls allerdings noch der verkürzte Impuls überlagert, der jedoch z.B. durch einen Hochpaß weggefiltert werden kann. Wird der entstandene Mikrowellenpuls jedoch in einem Hohlleiter weitergeführt, kann auf den zusätzlichen Hochpaß verzichtet werden, da der Hohlleiter das gleiche Verhalten aufweist.

Die beschriebene Anordnung ermöglicht die Verkürzung der vom Impulsgenerator 1 zugeführten Impulse als einstellbare Impulslängen von etwa 0,5 ns bis zur Länge der Eingangsimpulse. Die Einstellung der Impulslänge erfolgt über den ohmschen Widerstand 8 und den Kondensator 9. Dabei ist der ohmsche Widerstand als Trimmpotentiometer ausgeführt Der Kondensator 9 weist-eine feste Kapazität auf. Die Verstellung des Trimmpotentiometers 8 erfolgt bisher regelmäßig von Hand.

Durch die sehr hohen Frequenzanteile beim Betrieb des Mikroweilen-Pulsgenerators ist der Einsatz von Trimmpotentiometern jedoch kritisch. Die hohen Frequenzanteile sind durch die sehr kurzen Anstiegszeiten der Eingangssignale bedingt. Durch den mechanischen Aufbau der Anordnung sind die parasitären Kapazitäten und Induktivitäten der Schaltungsanordnung verhältnismäßig groß. Die hohen Frequenzanteile werden außerdem stark abgestrahlt. Insgesamt wird die gesamte Schaltungsanordnung dadurch verhältnismäßig empfindlich gegenüber Annäherungen bzw. bei Berühren des Potentiometers.

Darüber hinaus hat es sich herausgestellt, dass die manuelle Handhabung des Potentiometers zum Einstellen der Impulslänge bei einem Abgleich in der Fertigung der Mikrowellen-Pulsgeneratoren nicht optimal ist. Der Handabgleich der Trimmpotentiometer ist einer automatischen Fertigung hinderlich.

Hier setzt die vorliegende Erfindung an.

Das Ziel der vorliegenden Erfindung wird darin gesehen, die bisher bekannte Schaltungsanordnung so abzuändern, dass einerseits die gesamte Schaltung unempfindlicher gegenüber Annäherungen ist und andererseits ein automatischer Abgleich erfolgen kann, die eine manuelle Handhabung der Schaltungsanordnung vermeidet.

Diese Aufgabe wird durch einen Mikrowellen-Pulsgenerator mit den Merkmalen des Anspruchs 1 gelöst.

Weiterbildungen sind Gegenstand der Unteransprüche.

Die Erfindung beruht im wesentlichen darauf, das bisher verwendete RC-Glied mit Trimmpotentiometer durch eine Einrichtung zu ersetzen, die nach Maßgabe eines elektronischen Steuersignals die Amplitude und/oder Länge der zu erzeugenden Mikrowellen-Pulse einstellt.

Gemäß einer bevorzugten Ausführungsform der Erfindung wird eine solche Einrichtung zweckmäßigerweise durch einen festen Widerstand und eine Kapazitätsdiode, die über eine an der Diode angelegte Spannung ihre Kapazität verändert, realisiert.

Wesentlich bei der vorliegenden Erfindung ist, dass die Einstellung der Mikrowellen-Pulse potentiometerfrei erfolgt.

Zweckmäßigerweise weist die Einrichtung zur Steuerung der Amplitude und/oder Länge der erzeugenden Mikrowellen-Pulse einen Kondensator zur gleichstrommäßigen Abkopplung des elektronischen Steuersignals auf.

Der erfindungsgemäße Mikrowellen-Pulsgenerator kann Bestandteil einer Sensoreinrichtung sein, bei welcher ein Mikroprozessor über einen einstellbaren Spannungsregler ein elektronisches Steuersignal für die lmpulsverkürzungsstufe bereitstellt. Dabei ist die Impulsverkürzungsstufe und/oder der Mikrowellenoszillator über eine Rückkopplungseinrichtung mit dem Mikroprozessor in Verbindung. Die Rückkopplungseinrichtung kann beispielsweise ein Prüfstand sein.

Die Erfindung wird nachfolgend im Zusammenhang mit weiteren Figuren anhand eines konkreten Ausführungsbeispieles näher erläutert. Es zeigen:
Figur 1 ein Blockschaltbild einer bekannten Anordnung eines Mikrowellen-Pulsgenerators,
Figur 2 ein Ausführungsbeispiel für eine bekannte Impulsverkürzungsstufe mit nachgeschalteter Treiberstufe,
Figur 3 ein bekanntes Ausführungsbeispiel für einen Mikrowellen-Oszillator,
Figur 4 eine Impulsverkürzungsstufe mit nachgeschaltetem Verstärker gemäß einem Ausführungsbeispiel der vorliegenden Erfindung,
Figur 5 ein Blockschaltbild für eine Abgleicheinrichtung mit einem Mikrowellen-Pulsgenerator, und
Figur 6 ein Blockschaltbild einer rückgekoppelten Sensoreinrichtung mit einem Mikrowellen-Oszillator nach der Erfindung.

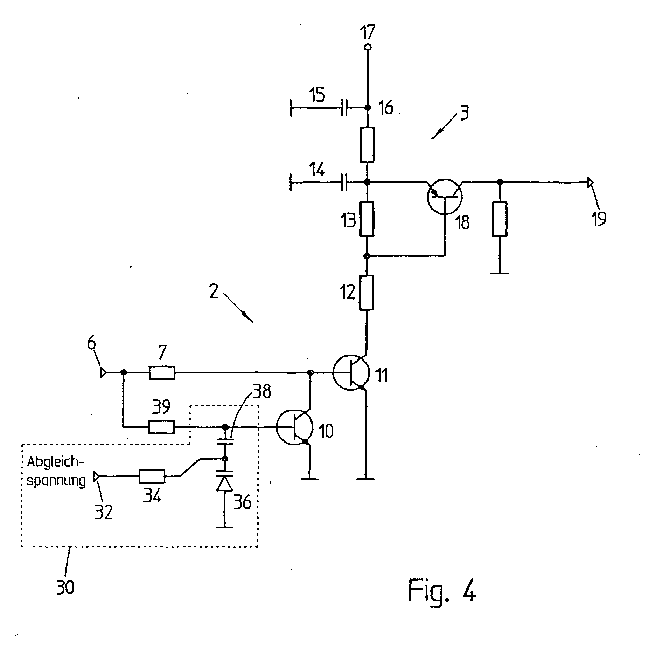

Die in Figur 4 dargestellte Schaltungsanordnung einer Impulsverkürzungsstufe 2 mit nachgeschaltetem Verstärker 3 unterscheidet sich von der Schaltungsanordnung in Figur 2 lediglich in der Ansteuerung des Transistors 10. Der Steueranschluß des Transistors 10 ist über einen Widerstand 39 mit der Eingangsklemme 6 in Verbindung. Zusätzlich ist der Steueranschluß des Transistors 10 über einen Kondensator 38 und eine Kapazitätsdiode 36 mit Bezugspotential in Verbindung. Die Kapazitätsdiode ist dabei so gepolt, dass deren Anodenanschluß mit Bezugspotential in Verbindung steht und deren Kathodenanschluß an den Kondensator 38 angeschlossen ist. Der Verbindungspunkt vom Kondensator 38 und Kapazitätsdiode 36 ist über einen Widerstand 34 mit einer Eingangsklemme 32 verbunden.

An dieser Eingangsklemme 32 ist ein elektronisches Steuersignal, im vorliegenden Beispiel eine Abgleichspannung, anlegbar, um die Amplitude und/oder Länge der an der Klemme 6 bereitgestellten Impulse einzustellen. Die aus den Schaltungsteilen 34, 36 und 38 bestehende Einrichtung 30 hat gegenüber der in Figur 2 dargestellten Anordnung aus Trimmpotentiometer 8 und Kondensator 9 den entscheidenden Vorteil, dass kein manuelles Verstellen zum Einstellen der Impulslänge bzw. Impulsamplitude notwendig ist. Insgesamt ist die Schaltungsanordnung deshalb deutlich unempfindlicher gegen Annäherung von Personen. Des weiteren kann die Anordnung elektronisch eingestellt werden. Ein manueller Eingriff ist nicht notwendig.

Mit der Anordnung von Figur 4 hat man also die Möglichkeit, die Pulslängen bzw. Amplitude durch eine von außen angelegte Gleichspannung zu variieren. Die Abgleichspannung kann dabei z. B. von einem einstellbaren Spannungsregler, einem digitalen oder einem herkömmlichen Potentiometer oder einem D/A-Wandler geliefert werden. Die schnellen Flanken der Eingangsimpulse müssen nicht mehr über ein Potentiometer mit großen parasitären Kapazitäten und Induktivitäten geführt werden, wie dies in der Anordnung von Figur 2 der Fall war. Das elektronische Steuersignal, hier also die Abgleichspannung an der Klemme 32, kann weiter entfernt von der Mikrowellenshaltung für den Amplituden- bzw. Pulslängenabgleich erzeugt werden.

Die Funktionsweise der Schaltungsanordnung von Figur 4 ist folgende. Am Widerstand 7 werden Impulse mit z. B. 10 nsec Impulslänge von dem Impulsgenerator 1 angelegt. Dadurch wird der Transistor 11 leitend. Die am Widerstand 7 angelegten Impulse werden gleichzeitig über den Widerstand 39 an den Steueranschluss des Transistors 10 zugeführt. Zusammen mit der Reihenschaltung des Kondensators 38 und der Kapazitätsdiode 26 bildet der Widerstand 39 ein Verzögerungsglied, welches die and er Klemme 6 angelegten Eingangsimpulse verzögert an den Transistor 10 weitergibt und dadurch diesen wieder sperrt. Der so entstandene kurze Puls mit einer Länge im Bereich von etwa 1 nsec wird am Transistor 18 invertiert, so dass dieser verkürzte Impuls am Kollektorenanschluss des Transistors 18 und damit an der. Klemme 19 abgreifbar ist.

über den Widerstand24 der Einrichtung 30 kann an der Kapazitätsdiode 36 eine Abgleichsspannung zur Kapazitätsänderung zugeführt werden. Damit wird durch die Abgleichsspannung die Impulslänge im Bereich von etwa 0,5 nsec bis zur Eingangsimpulslänge variiert. Der Kondensator 38 dient lediglich zur gleichmäßigen Abkopplung der Abgleichspannung und ist wesentlich größer als die an der Kapazitätsdiode 36 maximal einstellbare Kapazität.

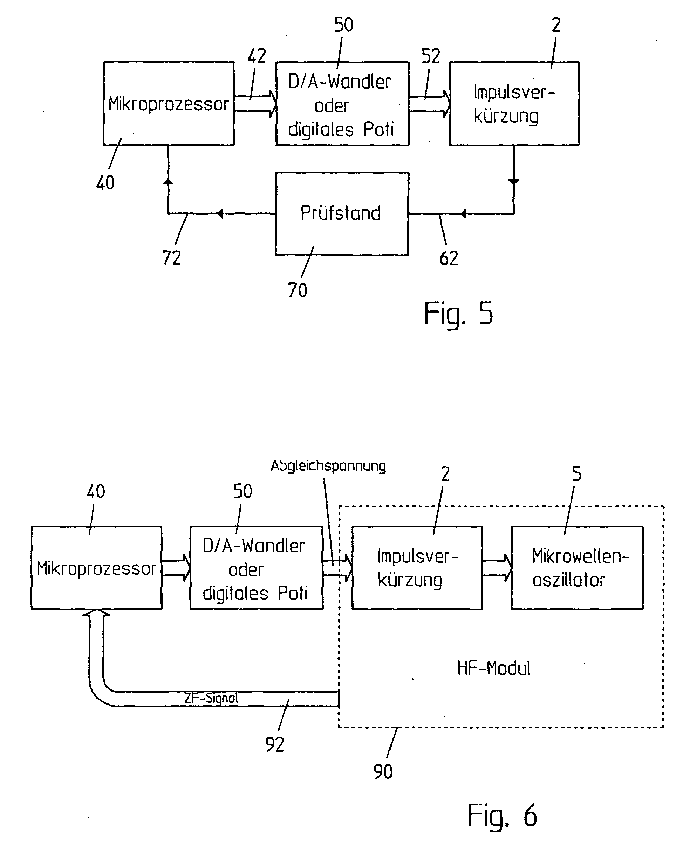

Während des Abgleichprozesses kann z. B. ein Pulslängenmessgerät eines Prüfstandes 70 mit einem Mikroprozessor 40 einer Sensoreinrichtung kommunizieren und einen Wert für die Abgleichspannung bestimmen, welchen der Mikroprozessor 40 über einen D/A-Wandler oder ein digitales Potentiometer 50 einstellt. Dies ist in Figur 5 dargestellt. Die einzelnen Komponenten sind über Verbindungsleitungen 42, 52 sowie 62 und 72 miteinander in Verbindung. Damit entfällt der bisher übliche aufwendige Handabgleich des Sendepulses bei Radar-Modulen.

In Figur 6 ist eine weitere Möglichkeit dargestellt, die während des Betriebes einer Sensoreinrichtung z. B. die Sendeleistung des Sensor für große Messdistanzen oder bei schlechten Reflexionseigenschaften des Füllgutes erhöht werden kann, um eine genügend hohe Messsicherheit zu erreichen. Dazu ist das HF-Modul, zu dem die Impulsverkürzungsstufe 2 und der Mikrowellen-Oszillator 5 gehören, über eine Verbindungsleitung 92 mit dem Mikroprozessor 40 verbunden. Während des Abgleichs kann beispielsweise die Sendeleistung des Sensors in Abhängigkeit von der Abgleichspannung aufgezeichnet und in einem Speicher des Mikroprozessors abgespeichert werden. Der Mikroprozessor ruft dann bei fallender Sendeleistung einen Wert für eine notwendige Abgleichspannung auf bzw. ab und liefert ein Steuersignal an den D/A-Wandler 50, so dass die Abgleichspannung entsprechend erhöht wird, um die Sendeleistung wieder auf den gewünschten Wert zu bringen.

### Bezugszeichenliste

- 1: Impulsgenerator
- 2: Impulsverkürzungsstufe
- 3: Treiberstufe
- 4: Entkopplungsnetzwerk
- 5: Mikrowellen-Oszillator
- 6: Eingangsklemme
- 7: Widerstand
- 8: Widerstand
- 9: Kapazität
- 10: Transistor
- 11: Transistor
- 12: Widerstand
- 13: Widerstand
- 14: Entkopplungskapazität
- 15: Entkopplungskapazität
- 16: Widerstand
- 17: Versorgungsspannungsklemme
- 18: Transistor
- 19: Ausgangsklemme
- 20: Versorgungsklemme
- 21: Widerstand
- 23: Kapazität
- 24: Ausgangsklemme
- 25: Transistor, Halbleiterverstärker
- 26: Widerstand
- 30: Einrichtung
- 32: Eingangsklemme
- 34: Widerstand
- 36: Kapazitätsdiode
- 38: Kondensator
- 39: Widerstand
- 40: Mikroprozessor
- 42: Leitung
- 50: D/A-Wandler oder digitales Poti
- 52: Leitung
- 62: Leitung
- 70: Prüfstand
- 72: Leitung
- 90: HF-Modul
- 92: Leitung

- A: circular stub
- B: λ/4-Leitung

## Patentansprüche

1. Mikrowellen-Pulsgenerator zur Erzeugung von Mikrowellen-Pulsen im Nanosekundenbereich mit einem Impulsgenerator (1), einer Impulsverkürzungsstufe (2), der die Impulse mit einer vorgegebenen Impulsperiode des Impulsgenerators (1) zuführbar sind und durch welche Ausgangsimpulse im Nanosekundenbereich erzeugbar sind, und mit einem Mikrowellenoszillator (5), dem die Ausgangsimpulse zuführbar sind zur Erzeugung der Mikrowellen-Pulse,
**dadurch gekennzeichnet, dass**
die Impulsverkürzungsstufe (2) eine an einer Eingangsklemme (32) mit einem elektrischen Steuersignal zu beaufschlagenden Einrichtung (30), durch welche die Amplitude und/oder Länge der zu erzeugenden Mikrowellen-Pulse steuerbar ist, aufweist.

2. Mikrowellen-Pulsgenerator nach Anspruch 1,
**dadurch gekennzeichnet, dass** durch die Einrichtung (30) zusätzlich die Amplitude der zu erzeugenden Mikrowellen-Pulse steuerbar ist.

3. Mikrowellen-Pulsgenerator nach Anspruch 1 oder 2,
**dadurch gekennzeichnet, dass** die Einrichtung (30) potentiometerfrei ausgebildet ist.

4. Mikrowellen-Pulsgenerator nach einem der Ansprüche 1 bis 3,
**dadurch gekennzeichnet, dass** die Einrichtung (30) Bestandteil der Impulsverkürzungsstufe (2) ist.

5. Mikrowellen-Pulsgenerator nach einem der Ansprüche 1 bis 4,
**dadurch gekennzeichnet, dass** die Einrichtung (30) eine ohmsche Anordnung (34) und eine Kapazitätsdiodenanordnung (36) aufweist, wobei als elektronisches Steuersignal (32) ein an die Kapazitätsdiodenanordnung (36) anzulegendes Spannungssignal vorgesehen ist zur Steuerung des Kapazitätswertes der Kapazitätsdiodenanordnung (36).

6. Mikrowellen-Pulsgenerator nach einem der Ansprüche 1 bis 5,
**dadurch gekennzeichnet, dass** die Kapazitätsdiodenanordnung (36) eine Kapazitätsdiode und die ohmsche Anordnung (34) ein ohmscher Widerstand ist.

7. Mikrowellen-Pulsgenerator nach einem der Ansprüche 1 bis 6,
**dadurch gekennzeichnet, dass** die Einrichtung (30) einen Kondensator (38) zur gleichstrommäßigen Abkopplung des elektronischen Steuersignals (32) aufweist.

8. Mikrowellen-Pulsgenerator nach einem der vorhergehenden Ansprüche,
**dadurch gekennzeichnet, dass** die Impulsverkürzungsstufe (2) aufweist:
- einen ersten Transistor (11), dessen Steueranschluss die Impulse konstanter Impulsbreite zugeführt werden, und über dessen Laststrecke die Ausgangsimpulse ausgekoppelt werden,
- einen zweiten Transistor (10), dessen Laststrecke zwischen dem Steueranschluss des ersten Transistors (11) und einem Bezugspotential geschaltet ist, und dessen Steueranschluss über einen ohmschen Widerstand (39) mit dem Ausgang des Impulsgenerators (1) und über die Einrichtung (30) mit der Klemme für das elektronische Steuersignal verbunden ist.

9. Mikrowellen-Pulsgenerator nach Anspruch 8,
**dadurch gekennzeichnet, dass** die Laststrecke des ersten Transistors (11) einerseits mit dem Bezugspotential verschaltet ist und andererseits über einen Widerstandsteiler (12, 13) mit einer Versorgungsspannungsklemme (17) verbunden ist, und einem der Widerstände (13) des Widerstandsteilers (12, 13) die Emitter-Basis-Strecke eines dritten Transistors (18) parallel geschaltet ist und die Ausgangsimpulse am Kollektor des dritten Transistors (18) abgreifbar sind.

10. Mikrowellen-Pulsgenerator nach Anspruch 6, 7 und 8,
**dadurch gekennzeichnet, dass** der Steueranschluss des zweiten Transistors (10) über den Widerstand (39) an den Ausgang des Impulsgenerators (1) und über die Reihenschaltung des Kondensators (38) und der Kapazitätsdiode an Bezugspotential geschaltet ist, wobei ein Verbindungspunkt dieses Kondensators (38) und der Kapazitätsdiode über einen weiteren ohmschen Widerstand (40) an eine Klemme (42) zum Anlagen des elektrischen Steuersignals geschaltet ist.

11. Mikrowellen-Pulsgenerator nach einem der vorgehenden Ansprüche,
**dadurch gekennzeichnet, dass** zwischen Impulsverkürzungsstufe (2) und Mikrowellenoszillator eine Treiberstufe (3) geschaltet ist.

12. Mikrowellen-Pulsgenerator nach einem der vorhergehenden Ansprüche,
**dadurch gekennzeichnet, dass** zwischen Impulsverkürzungsstufe (2) und Mikrowellenoszillator (1) eine Entkopplungsstufe (4) geschaltet ist.

13. Mikrowellen-Pulsgenerator nach Anspruch 12,
**dadurch gekennzeichnet, dass** die Entkopplungsstufe (4) eine Circular Stub (A) enthält.

14. Mikrowellen-Pulsgenerator nach einem der vorhergehenden Ansprüche,
**dadurch gekennzeichnet, dass** das elektronische Steuersignal von einem einstellbaren Spannungsregler, insbesondere einem digitalen Potentiometer oder einem D/A-Wandler, bereitgestellt wird.

15. Sensoreinrichtung mit einem Mikrowellen-Pulsgenerator nach einem der vorhergehenden Ansprüche, wobei ein Mikroprozessor (42) über einen einstellbaren Spannungsregler (50) ein elektronisches Steuersignal für die Impulsverkürzungsstufe (2) bereitstellt, und wobei die Impulsverkürzungsstufe (2) und/oder der Mikrowellenoszillator (5) über eine Rückkopplungseinrichtung mit dem Mikroprozessor (40) in Verbindung steht.

16. Sensoreinrichtung nach Anspruch 15,
**dadurch gekennzeichnet, dass** die Rückkopplungseinrichtung ein Prüfstand (70) ist.

17. Sensoreinrichtung nach Anspruch 15,
**dadurch gekennzeichnet, dass** die Rückkopplungseinrichtung dem Mikroprozessor (40) während des Betriebes des Sensors ein Signal über die augenblickliche Sendeleistung bereitstellt und eine Speichereinrichtung vorgesehen ist, in welcher die Sendeleistung des Sensors in Abhängigkeit des elektronischen Steuersignals gespeichert ist, damit im Bedarfsfall hiervon ausgehend die Sendeleistung des Sensors erhöht werden kann.

## Claims

1. A microwave pulse generator for generating microwave pulses in the nanosecond range with a pulse generator (1), a pulse-shortening stage (2) to which the pulses are capable of being supplied with a pre-determined pulse period of the pulse generator (1) and by which output pulses in the nanosecond range are capable of being generated, and with a microwave oscillator (5) to which the output pulses are capable of being supplied in order to generate the microwave pulses, **characterised in that** the pulse-shortening stage (2) has a device (30) which is to be acted upon at an input terminal (32) by an electrical control signal and by which the amplitude and/or length of the microwave pulses to be generated is capable of being controlled.

2. A microwave pulse generator according to claim 1, **characterised in that** the amplitude of the microwave pulses to be generated is additionally capable of being controlled by the device (30).

3. A microwave pulse generator according to claim 1 or 2, **characterised in that** the device (30) is designed to be potentiometer-free.

4. A microwave pulse generator according to any one of claims 1 to 3, **characterised in that** the device (30) is a component part of the pulse-shortening stage (2).

5. A microwave pulse generator according to any one of claims 1 to 4, **characterised in that** the device (30) has an ohmic arrangement (34) and a varicap-diode arrangement (36), wherein a voltage signal to be applied to the varicap-diode arrangement (36) is provided as an electronic control signal (32) to control the capacitance value of the varicap-diode arrangement (36).

6. A microwave pulse generator according to any one of claims 1 to 5, **characterised in that** the varicap-diode arrangement (36) is a varicap diode and the ohmic arrangement (34) is an ohmic resistor.

7. A microwave pulse generator according to any one of claims 1 to 6, **characterised in that** the device (30) has a capacitor (38) for direct-current decoupling of the electronic control signal (32).

8. A microwave pulse generator according to any one of the preceding claims, **characterised in that** the pulse-shortening stage (2) has
- a first transistor (11), to the control terminal of which the pulses of constant pulse width are supplied and by way of the load path of which the output pulses are decoupled,
- a second transistor (10), the load path of which is connected between the control terminal of the first transistor (11) and a reference potential and the control terminal of which is connected by way of an ohmic resistor (39) to the output of the pulse generator (1) and by way of the device (30) to the terminal for the electronic control signal.

9. A microwave pulse generator according to claim 8, **characterised in that** the load path of the first transistor (11) is connected at one end to the reference potential and at the other end by way of a resistance divider (12, 13) to a supply-voltage terminal (17), and the base-emitter path of a third transistor (18) is connected in parallel to one of the resistors (13) of the resistance divider (12, 13), and the output pulses are capable of being picked off at the collector of the third transistor (18).

10. A microwave pulse generator according to claims 6, 7 and 8, **characterised in that** the control terminal of the second transistor (10) is connected by way of the resistor (39) to the output of the pulse generator (1) and by way of the series circuit of the capacitor (38) and the varicap diode to reference potential, wherein a connection point of this capacitor (38) and the varicap diode is connected by way of a further ohmic resistor (40) to a terminal (42) for applying the electrical control signal.

11. A microwave pulse generator according to any one of the preceding claims, **characterised in that** a driver stage (3) is connected between the pulse-shortening stage (2) and the microwave oscillator.

12. A microwave pulse generator according to any one of the preceding claims, **characterised in that** a decoupling stage (4) is connected between the pulse-shortening stage (2) and the microwave oscillator (1).

13. A microwave pulse generator according to claim 12, **characterised in that** the decoupling stage (4) contains a circular stub (A).

14. A microwave pulse generator according to any one of the preceding claims, **characterised in that** the electrical control signal is provided by an adjustable voltage regulator, in particular a digital potentiometer or a D/A converter.

15. A sensor device with microwave pulse generator according to any one of the preceding claims, wherein a microprocessor (42) provides an electronic control signal for the pulse-shortening stage (2) by way of an adjustable voltage regulator (50), and wherein the pulse-shortening stage (2) and/or the microwave oscillator (5) is or are connected by way of a feedback device to the microprocessor (40).

16. A sensor device according to claim 15, **characterised in that** the feedback device is a test bench (70).

17. A sensor device according to claim 15, **characterised in that** during the operation of the sensor the feedback device provides the microprocessor (40) with a signal by way of the instantaneous transmission power, and a memory device is provided in which the transmission power of the sensor is stored in a manner dependent upon the electronic control signal so that if necessary the transmission power of the sensor can be increased on the basis thereof.

## Revendications

1. Générateur d'impulsions de micro-ondes pour générer des impulsions de micro-ondes dans le domaine des nanosecondes comprenant un générateur d'impulsions (1), un étage réducteur d'impulsions (2) qui reçoit les impulsions avec une période d'impulsions prédéfinie du générateur d'impulsions (1) et génère des impulsions de sortie dans la plage des nanosecondes ainsi qu'un oscillateur de micro-ondes (5) recevant les impulsions de sortie pour générer des impulsions de micro-ondes,
**caractérisé en ce que**
l'étage réducteur d'impulsions (2) comporte une installation (30) dont une borne d'entrée (32) reçoit un signal de commande électrique pour commander l'amplitude et/ou la longueur de l'impulsion de micro-ondes à générer.

2. Générateur d'impulsions de micro-ondes selon la revendication 1,
**caractérisé en ce que**
l'installation (30) commande aussi l'amplitude de l'impulsion de micro-ondes à générer.

3. Générateur d'impulsions de micro-ondes selon la revendication 1 ou 2,
**caractérisé en ce que**
l'installation (30) ne comporte pas de potentiomètre.

4. Générateur d'impulsions de micro-ondes selon l'une des revendications 1 à 3,
**caractérisé en ce que**
l'installation (30) fait partie de l'étage réducteur d'impulsions (2).

5. Générateur d'impulsions de micro-ondes selon l'une des revendications 1 à 4,
**caractérisé en ce que**
l'installation (30) comporte un montage ohmique (34) et un montage de diode capacitive (36),
le signal de commande électronique (32) étant un signal de tension appliqué au montage de diode capacitive (36) pour commander la capacité du montage de diode capacitive (36).

6. Générateur d'impulsions de micro-ondes selon l'une des revendications 1 à 5,
**caractérisé en ce que**
le montage de diode capacitive (36) est une diode capacitive et le montage ohmique (34) est une résistance ohmique.

7. Générateur d'impulsions de micro-ondes selon l'une des revendications 1 à 6,
**caractérisé en ce que**
l'installation (30) comporte un condensateur (38) pour découpler en courant continu le signal de commande électronique (32).

8. Générateur d'impulsions de micro-ondes selon l'une des revendications précédentes,
**caractérisé en ce que**
l'étage réducteur d'impulsions (2) comporte :
- un premier transistor (11) dont la borne de commande reçoit des impulsions ayant une largeur d'impulsion constante et dont le chemin de charge découple les impulsions de sortie, et
- un second transistor (10) dont le chemin de charge est branché entre la borne de commande du premier transistor (11) et un potentiel de référence et dont la borne de commande est reliée par une résistance ohmique (39) à la sortie du générateur d'impulsions (1) et par l'installation (30) à la borne du signal de commande électronique.

9. Générateur d'impulsions de micro-ondes selon la revendication 8,
**caractérisé en ce que**
le chemin de charge du premier transistor (11) est d'une part relié au potentiel de référence et d'autre part à une borne de tension d'alimentation (17), par l'intermédiaire d'un diviseur à résistances (12, 13), et l'une des résistances (13) du diviseur (12, 13) a en parallèle le chemin émetteur-base d'un troisième transistor (18) et les signaux de sortie sont prélevés sur le collecteur du troisième transistor (18).

10. Générateur d'impulsions de micro-ondes selon les revendications 6, 7, 8,
**caractérisé en ce que**
- la borne de commande du second transistor (10) est reliée par la résistance (39) à la sortie du générateur d'impulsions (1) et par le montage en série du condensateur (38) et de la diode capacitive, à un potentiel de référence, et
- le point de jonction du condensateur (38) et de la diode capacitive est relié par l'intermédiaire d'une autre résistance ohmique (40) à une borne (42) pour appliquer le signal électrique de commande.

11. Générateur d'impulsions de micro-ondes selon l'une des revendications précédentes,
**caractérisé en ce qu'**
un étage pilote (3) est branché entre l'étage réducteur d'impulsions (2) et l'oscillateur de micro-ondes.

12. Générateur d'impulsions de micro-ondes selon l'une des revendications précédentes,
**caractérisé par**
un étage de découplage (4) branché entre l'étage réducteur d'impulsions (2) et l'oscillateur de micro-ondes (1).

13. Générateur d'impulsions de micro-ondes selon la revendication 12,
**caractérisé en ce que**
l'étage de découplage (4) comporte une ligne de branchement circulaire.

14. Générateur d'impulsions de micro-ondes selon l'une des revendications précédentes,
**caractérisé en ce que**
le signal de commande électronique est fourni par un régulateur de tension réglable, notamment un potentiomètre numérique ou un convertisseur numérique/analogique.

15. Installation de capteur comportant un générateur d'impulsions de micro-ondes selon l'une des revendications précédentes, avec un microprocesseur (40) fournissant par l'intermédiaire d'un régulateur de tension (50) réglable, un signal de commande électronique à l'étage réducteur d'impulsions (2), et
l'étage réducteur d'impulsions (2) et/ou l'oscillateur de micro-ondes (5) sont reliés au microprocesseur (40) par l'intermédiaire d'une installation de couplage en retour.

16. Installation de capteur selon la revendication 15,
**caractérisée en ce que**
l'installation de couplage en retour est un banc d'essai (70).

17. Installation de capteur selon la revendication 15,
**caractérisée en ce que**
l'installation de couplage en retour fournit à un microprocesseur (40) pendant le fonctionnement du capteur, un signal concernant la puissance d'émission instantanée et une installation d'alimentation est prévue dans laquelle est enregistrée la puissance d'émission du capteur en fonction du signal de commande électronique pour qu'en cas de besoin, on puisse à partir de là, augmenter la puissance d'émission du capteur.
